# EUROPEAN PATENT APPLICATION

(11) **EP 4 539 637 A1**
(43) Date of publication of application: **16.04.2025**
(21) Application number: 24201900.8
(22) Date of filing: 23.09.2024
(51) Int. Cl.: H10F 39/00

(54) **CAMERA SIZE REDUCTION WITH ADHESIVE OR DAM COMPOUND**

(30) Priority: 12.10.2023 US 202363543777 P; 16.09.2024 US 202418886915
(71) Applicant: Meta Platforms Technologies, LLC, Menlo Park, CA 94025 (US)
(72) Inventor: Liao, Guangxun, Menlo Park (US); Kha, Kevin, Menlo Park (US); Bardagjy, Andrew Matthew, Menlo Park (US); Liang, Minhua, Menlo Park (US); Hazegh, Cina, Menlo Park (US); Bie, Linsen, Menlo Park (US); Xiong, Yizhi, Menlo Park (US); Tenggoro, Anthony Aslan, Menlo Park (US)
(74) Representative: Murgitroyd & Company

(57) **Abstract**

A camera includes an image sensor package, a lens assembly, and an adhesive or dam compound. The image sensor package includes an image pixel array and support circuitry disposed around the image pixel array. The lens assembly includes a lens barrel disposed around lens elements configured to focus image light to the image pixel array. The adhesive or dam compound adheres the lens barrel to the support circuitry in an inactive area of the image sensor package.

## Description

### TECHNICAL FIELD

This disclosure relates generally to optics, and in particular to cameras.

### BACKGROUND INFORMATION

Cameras have become ubiquitous as they are placed in an increasing number of devices such as smartphones, tablets, watches, and action cameras. Resolution, dynamic range, signal quality, and image acquisition time are key performance metrics for cameras and the image sensors that are included in cameras. As cameras get smaller to be included in additional contexts and use-cases, some or all of these performance metrics become more difficult to meet.

### SUMMARY

According to an aspect, there is provided a camera comprising:
an image sensor package including an image pixel array, support circuitry disposed around the image pixel array;
a lens assembly including a lens barrel disposed around lens elements configured to focus image light to the image pixel array; and
an adhesive adhering to the lens barrel to bond the lens barrel to the support circuitry in an inactive area of the image sensor package.

The camera may further comprise a dam compound disposed between the adhesive and the inactive area of the image sensor package, wherein the dam compound was configured to adhere an image sensor coverglass to the image sensor package, and wherein the camera no longer includes the image sensor coverglass.

The dam compound may include glass fibers configured to bridge a coefficient of thermal expansion, CTE, between the image sensor package and the lens assembly.

The adhesive may be added to bond the lens assembly directly to the image sensor package.

The adhesive may be disposed on substantially all of the inactive area of the image sensor package.

The adhesive may be disposed on an indented portion of the inactive area of the image sensor package. A width of the lens assembly may be disposed inside the indented portion of the inactive area of the image sensor package.

A ball grid array of the image sensor package may be configured to be the sole mechanical support of the lens assembly between a circuit board and the lens assembly.

The lens barrel may be sized substantially similar to a length and width of the image sensor package.

The image sensor package may have a length and a width. The lens barrel may be sized no larger than 10% more than an area of the length multiplied by the width of the image sensor package.

The adhesive may be configured to block ambient light from becoming incident on the image pixel array.

The lens assembly may not be adhered to a molding configured to protect the image sensor package.

The image pixel array may be an active region of the image sensor package and the support circuitry is an inactive area of the image sensor package.

The image pixel array may be a complementary metal-oxide semiconductor, CMOS, image pixel array.

According to another aspect, there is provided a camera comprising:
an image sensor package including an image pixel array, support circuitry disposed around the image pixel array;
a lens assembly including a lens barrel disposed around lens elements configured to focus image light to the image pixel array;
a coverglass element configured to protect the image pixel array, wherein the coverglass element is disposed between the lens assembly and the image sensor package; and
an adhesive adhering the lens barrel to the coverglass element.

A ball grid array of the image sensor package may be configured to be the sole mechanical support of the lens assembly between a circuit board and the lens assembly.

The lens barrel may be sized substantially similar to a length and width of the image sensor package.

The image pixel array may be a complementary metal-oxide semiconductor, CMOS, image pixel array.

According to a further aspect, there is provided a fabrication method comprising:
receiving an image sensor package, wherein the image sensor package includes:
   an image pixel array;
   support circuitry disposed around the image pixel array; and
   a ball grid array configured to electrically couple the support circuitry to a circuit board;
disposing a dam compound along an outer boundary of the support circuitry of the image sensor package; and
applying a removeable protection shield on the dam compound to seal the image pixel array from contaminants.

The method may further comprise:
placing the image sensor package onto the circuit board by electrically coupling the ball grid array to the circuit board with a surface mount technology, SMT, machine; and
removing the removeable protection shield from the dam compound after the image sensor package has been placed onto the circuit board; and
bonding a lens assembly to the dam compound subsequent to the removeable protection shield being removed.

A lens barrel of the lens assembly may be sized substantially similar to a length and width of the image sensor package.

It will be appreciated that any features described herein as being suitable for incorporation into one or more aspects or embodiments of the present disclosure are intended to be generalizable across any and all aspects and embodiments of the present disclosure. Other aspects of the present disclosure can be understood by those skilled in the art in light of the description, the claims, and the drawings of the present disclosure. The foregoing general description and the following detailed description are exemplary and explanatory only and are not restrictive of the claims.

### BRIEF DESCRIPTION OF THE DRAWINGS

Non-limiting and non-exhaustive embodiments of the invention are described with reference to the following figures, wherein like reference numerals refer to like parts throughout the various views unless otherwise specified.
FIG. 1 illustrates a traditional camera where an image sensor package is soldered to a circuit board and a lens assembly is also glued or bonded to the circuit board.
FIG. 2 illustrates a camera configuration that may be referred to as Molding on Chip (MOC) due to lens assembly being glued to a molding that is adhered to circuit board.
FIG. 3A illustrates a camera that has a reduced width, in accordance with aspects of the disclosure.
FIG. 3B illustrates a camera having an adhesive disposed in an inactive area of an image sensor package, in accordance with aspects of the disclosure.
FIG. 3C illustrates a camera having an adhesive disposed on an indented portion of inactive area of image sensor package, in accordance with aspects of the disclosure.
FIG. 3D illustrates a camera including an adhesive adhering a lens barrel to a coverglass element, in accordance with aspects of the disclosure.
FIG. 4A illustrates a plan view of an image sensor package, in accordance with aspects of the disclosure.
FIG. 4B illustrates a plan view of image sensor having an example indented portion of inactive area, in accordance with aspects of the disclosure.
FIGs. 5A-5C illustrate an image sensor package having its coverglass removed and using an adhesive to adhere a lens assembly to the image sensor package, in accordance with aspects of the disclosure.
FIG. 6 illustrates an implementation where a dam compound is written directly to the bare image sensor to prepare the image sensor for active alignment with a lens assembly, in accordance with aspects of the disclosure.
FIG. 7 illustrates a fabrication process of a camera with coverglass removal, in accordance with aspects of the disclosure.
FIG. 8 illustrates a fabrication process of a camera that includes a removable protection shield, in accordance with aspects of the disclosure.

### DETAILED DESCRIPTION

Embodiments of reducing a camera size and image sensor size using an adhesive or a dam compound are described herein. In the following description, numerous specific details are set forth to provide a thorough understanding of the embodiments. One skilled in the relevant art will recognize, however, that the techniques described herein can be practiced without one or more of the specific details, or with other methods, components, materials, etc. In other instances, well-known structures, materials, or operations are not shown or described in detail to avoid obscuring certain aspects.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

Throughout this specification, several terms of art are used. These terms are to take on their ordinary meaning in the art from which they come, unless specifically defined herein or the context of their use would clearly suggest otherwise.

In aspects of this disclosure, visible light may be defined as having a wavelength range of approximately 380 nm - 700 nm. Non-visible light may be defined as light having wavelengths that are outside the visible light range, such as ultraviolet light and infrared light. Infrared light having a wavelength range of approximately 700 nm - 1 mm includes near-infrared light. In aspects of this disclosure, near-infrared light may be defined as having a wavelength range of approximately 700 nm - 1.6 µm.

In aspects of this disclosure, the term "transparent" may be defined as having greater than 90% transmission of light. In some aspects, the term "transparent" may be defined as a material having greater than 90% transmission of visible light.

Reducing a camera size allows camera modules to fit in more products and additional contexts. Cameras can be placed in electronic devices such as smartphones, tablets, vehicles, and drones. Reducing the size of a camera may also allow for the camera to be placed in a particular advantageous location in an Augmented Reality (AR), Mixed Reality (MR), or Virtual Reality (VR) device that was previously not possible, for example.

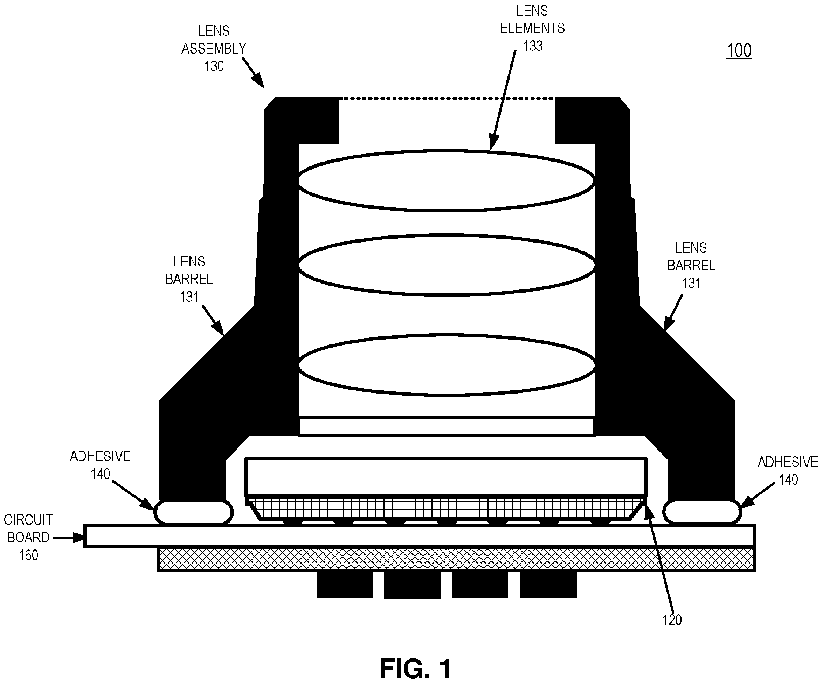

FIG. 1 illustrates a traditional camera 100 where an image sensor package 120 is soldered to a circuit board 160 and a lens assembly 130 is also glued or bonded to the circuit board 160 with an adhesive 140. Lens assembly 130 includes a lens barrel 131 that houses lens elements 133 that focus image light to the image sensor package 120. In FIG. 1, the lens assembly 130 of camera 100 is significantly wider than the image sensor package 120.

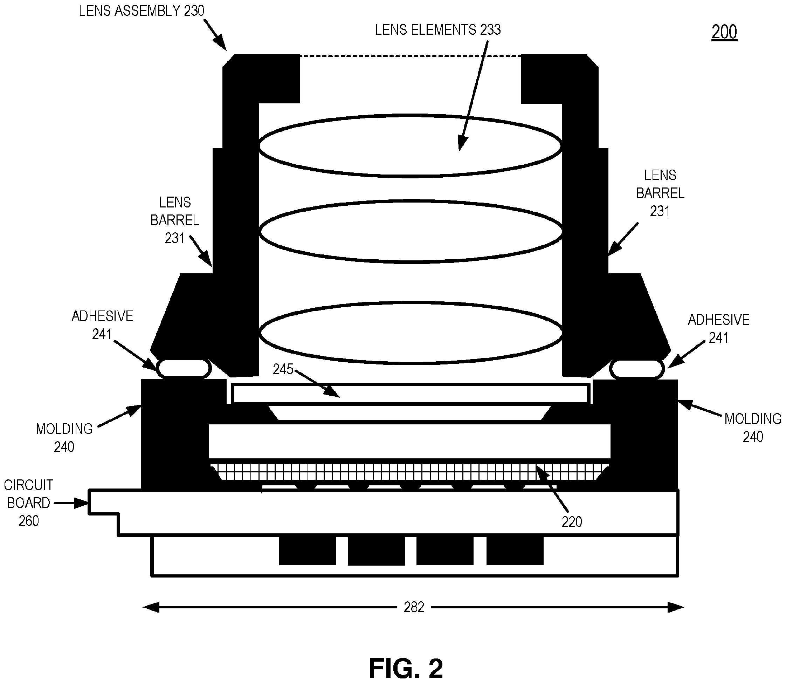

FIG. 2 illustrates a camera configuration 200 that may be referred to as Molding on Chip (MOC) due to lens assembly 230 being glued to a molding 240 with an adhesive 241. Molding 240 is adhered to circuit board 260. Lens assembly 230 includes a lens barrel 231 that houses lens elements 233 that focus image light to the image sensor package 220. The MOC configuration of camera 200 may reduce the overall size of the camera 200 that includes lens assembly 230, molding, and image sensor 220. Molding 240 may be part of an image sensor package that also includes image sensor 220 and coverglass 245. Coverglass 245 may serve to protect image sensor 220 from harm and contaminants during shipping and assembly processes. FIG. 2 shows that the width 282 of camera 200 is reduced compared to camera 100.

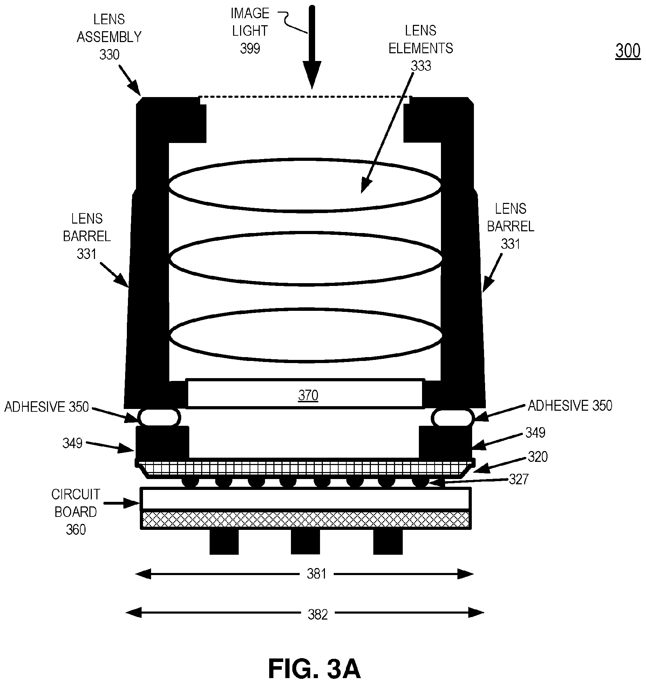

FIG. 3A illustrates a camera 300 that has a reduced width 382 compared to the width 282 of camera 200. In particular, the width 382 of camera 300 is substantially similar to the width 381 of image sensor 320, in FIG. 3A. Using the camera configuration illustrated in FIG. 3A may reduce the camera size (e.g. width and/or length) by 0.3 mm or more. Width 382 of camera 300 may be the same as the width of lens assembly 330. Lens assembly 330 includes lens barrel 331 and lens elements 333. Recent developments in lens assembly fabrication process techniques have enabled lens barrels 331 and lens elements 333 to become even smaller while still focusing image light 399 to image sensor package 320. In some implementations, lens assembly 330 may also include a filter assembly 370.

The filter assembly 370 may filter image light 399 propagating through lens elements 333 before reaching the image sensor package 320. In other implementations, filter assembly 370 may be disposed above some or all of lens elements 333. The filter assembly 370 may include one or more filters, such as: an infrared cut-off filter (IRCF), an infrared pass filter (IRPF), one or more other color filters, a micro lens positioned over each pixel of the image pixel array of image senor package 320, some other device for filtering light, or some combination thereof. The IRCF is a filter configured to block the infrared light and the ultraviolet light from the local area and propagate the visible light to the image senor package 320. The IRPF is a filter configured to block the visible light and ultraviolet light from the local area and propagate the infrared light to the image senor package 320.

In the illustration of FIG. 3A, there are three lens elements 333, although any number of lens elements may be included in lens barrel 331. Additionally, the lens elements may take different shapes such as rectangular shape, cubic shape, round shape, prism shape, freeform shape, or some other shape.

The illustrated image sensor package 320 includes an image pixel array, support circuitry (to initiate capturing images with the image pixel array) disposed around the image pixel array, and a ball grid array 327 configured to electrically coupled the support circuitry to the circuit board 360. Image sensor package 320 may be considered a chip scale package (CSP). The drawings of the disclosure may illustrate ball grid arrays (BGAs) included in the image sensor packages, although some image sensor packages contemplated by the disclosure may be without ball grid arrays while still being surface mount technology (SMT) components. Circuit board 360 may be a flex circuit or a rigid printed circuit board (PCB).

In FIG. 3A, an adhesive 350 adheres the lens barrel 331 to the support circuitry (non-active area) surrounding the image pixel array (active area). Adhesive 350 may include a glue that is dispensed or other adhesives such as pressure-sensitive adhesives (PSAs) or adhesive tape. In an implementation, a coverglass element is removed from image sensor package 320 and residual dam compound 349 remains with image sensor package 320. The residual dam compound 349 may be reflowed to adhere lens barrel 331 of lens assembly 330 to image sensor package 320. In some implementations, additional adhesive 350 is added to residual dam compound 349 to assist in adhering (bonding) lens barrel 331 to the image sensor package 320.

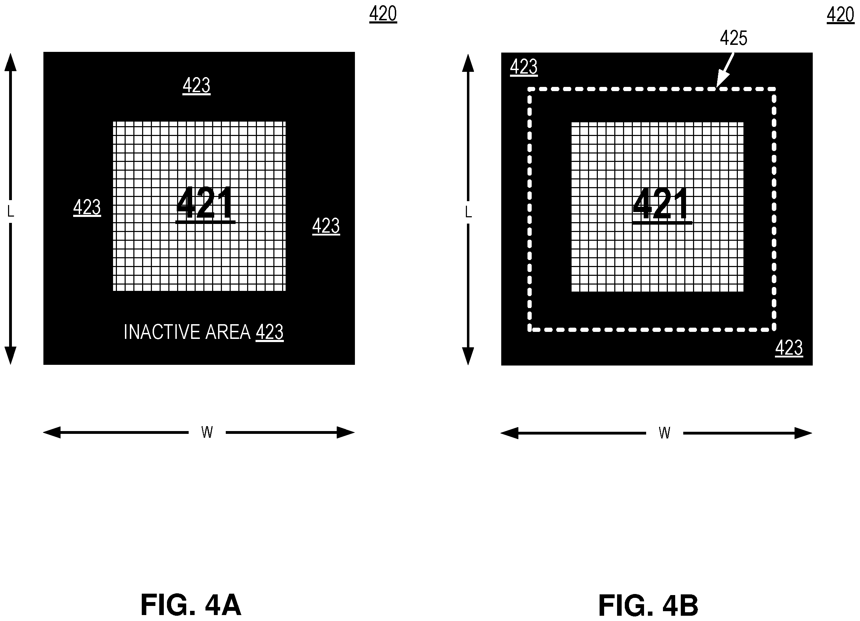

Dam compound 349 and/or adhesive 350 may adhere lens barrel 331 to the support circuitry in an inactive area of the image sensor package 320. Referring to FIG. 4A, the plan view of image sensor package 420 shows the image sensor package having an image pixel array in an active area 421 and support circuitry in an inactive area 423. The inactive area 423 may surround the active area 421. Image sensor package 420 has a length (L) and a width (W). L multiplied by W yields an area of image sensor package 420. The image pixel array in the active area 421 may be a complementary metal-oxide semiconductor (CMOS) image pixel array arranged in rows and columns.

Referring again to FIG. 3A, dam compound 349 and/or adhesive 350 may serve as a lens holder platform to support lens assembly 330. Dam compound 349 may include glass fibers and other materials to form a suitable coefficient of thermal expansion (CTE) bridge between image sensor package 320 and lens barrel 331. Dam compound 349 and/or adhesive 350 may also be configured to block incident ambient light from becoming incident on the image pixel array of image sensor package 320.

The dam compounds described in this disclosure may be a black color. The dam compounds described in this disclosure are opaque so that external ambient light will not propagate through the dam compound and become incident on the image pixel array of the image sensor package.

Camera 300 does not include a molding 240 (usually a plastic material) to support a lens assembly. In some implementations, ball grid array 327 of image sensor package 320 is configured to be the majority or sole mechanical support of lens assembly 330 between circuit board 360 and lens assembly 330.

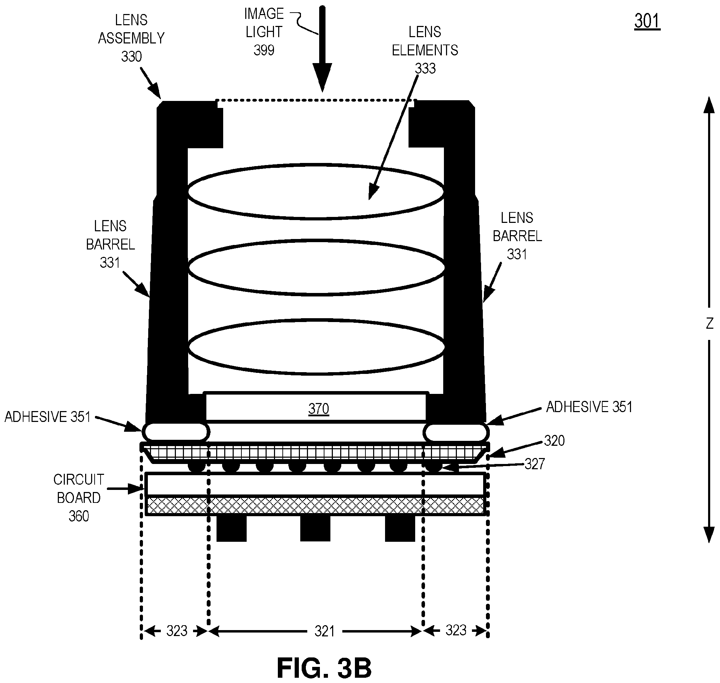

FIG. 3B illustrates a camera 301 having an adhesive 351 disposed in an inactive area 323 of image sensor package 320, in accordance with implementations of the disclosure. Adhesive 351 may include a glue that is dispensed or other adhesives such as pressure-sensitive adhesives (PSAs) or adhesive tape. In FIG. 3B, adhesive 351 is added to camera 301 without using any residual dam compound that was left over from a previously removed coverglass element of image sensor package 320. The residual dam compound may have been fully removed from image sensor package, in some implementations. In other implementations, image sensor package 320 is "glassless" and was not manufactured with coverglass and the corresponding dam compound that would have bonded the coverglass to the image sensor package. Consequently, there is no residual dam compound to remove from the image sensor package. Without residual dam compound in camera 301, it may further reduce the height (Z) of the camera 301.

FIG. 3B illustrates that adhesive 351 may be disposed in the inactive area 323 of image sensor package 320 (and not disposed in active area 321 of image sensor package). Adhesive 351 may be added to bond lens assembly 330 directly to image sensor package 320. In some implementations, adhesive 351 is disposed on substantially all of inactive area 323. This may provide a wider bonding surface for lens barrel 331 that is not possible if residual dam compound from coverglass is reflowed to bond lens assembly 330 to image sensor package 320.

Adhesive 351 may serve as a lens holder platform to support lens assembly 330. Adhesive 351 may include glass fibers and other materials to form a suitable coefficient of thermal expansion (CTE) bridge between image sensor package 320 and lens barrel 331. Adhesive 351 may also be configured to block incident ambient light from becoming incident on the image pixel array of image sensor package 320.

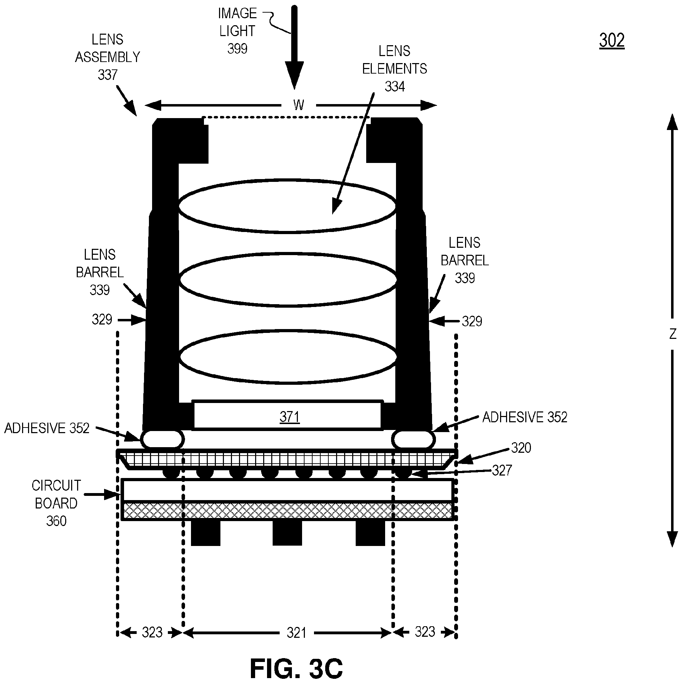

FIG. 3C illustrates a camera 302 having an adhesive 352 disposed on an indented portion of inactive area 323 of image sensor package 320, in accordance with implementations of the disclosure. Adhesive 352 may include a glue that is dispensed or other adhesives such as pressure-sensitive adhesives (PSAs) or adhesive tape. In FIG. 3C, adhesive 352 is added to camera 302 without using any residual dam compound that was left over from a previously removed coverglass element of image sensor package 320. The residual dam compound may have been fully removed from image sensor package, in some implementations. In other implementations, image sensor package 320 is "glassless" and was not manufactured with coverglass and the corresponding dam compound that would have adhered the coverglass to the image sensor package. Consequently, there is no residual dam compound to remove from the image sensor package.

In FIG. 3C, adhesive 352 is not disposed on the entire inactive area 323 of image sensor package 320. Rather, adhesive 352 is disposed on an indented portion of the image sensor package 320, which allows for a further reduction in a width (W) of lens barrel 339 of lens assembly 337. In FIG. 3C, indentation 329 represents the indented portion of inactive area 323 of image sensor package 320. FIG. 4B also shows a plan view of image sensor package 420 having an example indented portion 425 of inactive area 423 corresponding with the example indentation 329 of FIG. 3C. In implementations, the width (W) of the lens assembly 337 is disposed inside the indented portion of the inactive area of the image sensor package 320/420 to reduce the size of lens assembly 337. In some contexts, reducing the size of the lens assembly in a device is preferred since the lens assembly is the portion of a camera module visible on the outside of a device.

In FIG. 3C, lens assembly 337 includes lens barrel 339 and lens elements 334. In some implementations, lens assembly 337 may also include a filter assembly 371. The filter assembly 371 may filter image light 399 propagating through lens elements 334 before reaching the image sensor package 320. In other implementations, filter assembly 371 may be disposed above some or all of lens elements 334. The filter assembly 371 may include one or more filters, such as: an infrared cut-off filter (IRCF), an infrared pass filter (IRPF), one or more other color filters, a micro lens positioned over each pixel of the image pixel array of image senor package 320, some other device for filtering light, or some combination thereof. The IRCF is a filter configured to block the infrared light and the ultraviolet light from the local area and propagate the visible light to the image senor package 320. The IRPF is a filter configured to block the visible light and ultraviolet from the local area and propagate the infrared light to the image senor package 320. In the illustration of FIG. 3C, there are three lens elements 334, although any number of lens elements may be included in lens barrel 339. Additionally, the lens elements 334 may take different shapes such as rectangular shape, cubic shape, round shape, prism shape, freeform shape, or some other shape.

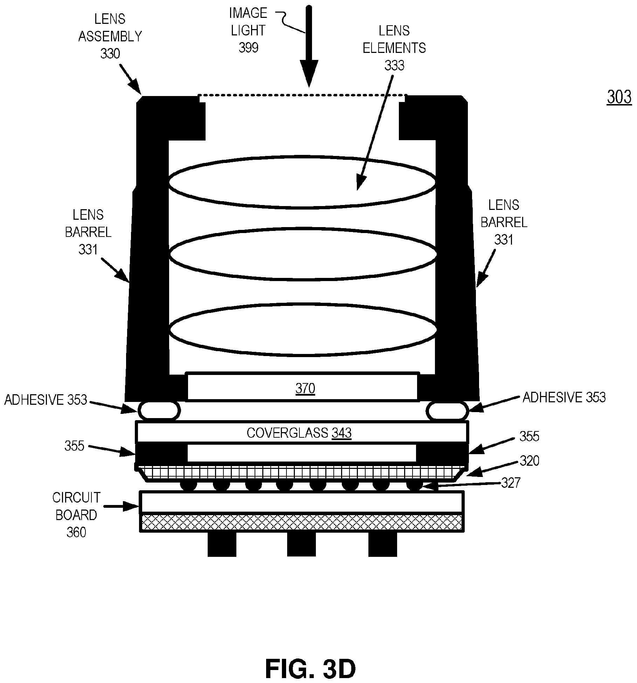

FIG. 3D illustrates a camera 303 including an adhesive 353 adhering lens barrel 331 to a coverglass element 343, in accordance with aspects of the disclosure. The illustrated image sensor package 320 includes an image pixel array, support circuitry (to initiate capturing images with the image pixel array) disposed around the image pixel array, and a ball grid array 327 configured to electrically coupled the support circuitry to the circuit board 360. Circuit board 360 may be a flex circuit or a rigid printed circuit board (PCB), for example. In FIG. 3D, coverglass element 343 is configured to protect the image pixel array of image sensor package 320. Coverglass element 343 is optically transparent so that image light 399 propagates through coverglass element 343 to become incident on the image pixel array of image sensor package 320. Coverglass element 343 is disposed between lens assembly 330 and the image sensor package 320. Dam compound 355 adheres coverglass element 343 to image sensor package 320. Adhesive 353 adheres the lens barrel 331 to the coverglass element 343. Adhesive 353 may include a glue that is dispensed or other adhesives such as pressure-sensitive adhesives (PSAs) or adhesive tape.

In an implementation of camera 303, ball grid array 327 of the image sensor package 320 is configured to be the sole mechanical support of lens assembly 330 between circuit board 360 and lens assembly 330. The lens barrel 331 may be sized substantially similar to a length and width of the image sensor package 320.

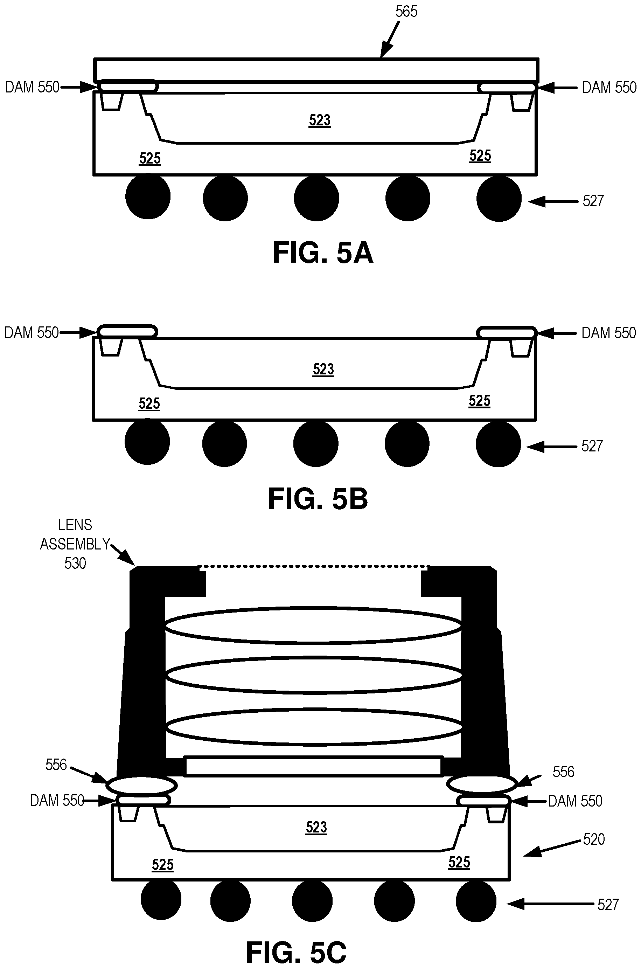

FIGs. 5A-5C illustrate an image sensor package having its coverglass removed and using the dam compound to adhere a lens assembly to the image sensor package, in accordance with aspects of the disclosure. FIG. 5A illustrates an image sensor package with an image pixel array 523 (silicon) and support circuitry 525 surrounding the image pixel array. Image pixel array 523 and support circuitry 525 may be separated by one or more metal layers and/or insulation layers (e.g. dielectric layers). Image pixel array 523 may be considered the "active region" and support circuitry 525 may be considered an "inactive region" of the image sensor package. The image sensor package also includes a ball grid array 527, in FIG. 5A. Coverglass 565 protects the image pixel array 523 from contaminants and a dam compound 550 bonds the coverglass 565 to the image sensor package.

In FIG. 5B, coverglass 565 has been removed and the dam compound 550 remains with the image sensor package.

In FIG. 5C, lens assembly 530 is bonded to the image sensor package with dam compound 550 serving as a lens holder platform. Bonding the lens assembly 530 may include active alignment techniques. Dam compound 550 may remain from the coverglass removal in FIG. 5B. Dam compound 550 may be reflowed to bond the lens assembly 530 to the image sensor package, in some implementations. In some implementations, an adhesive 556 is added to dam compound 550 to bond lens assembly 530 to the image sensor package 520 that includes ball grid array 527.

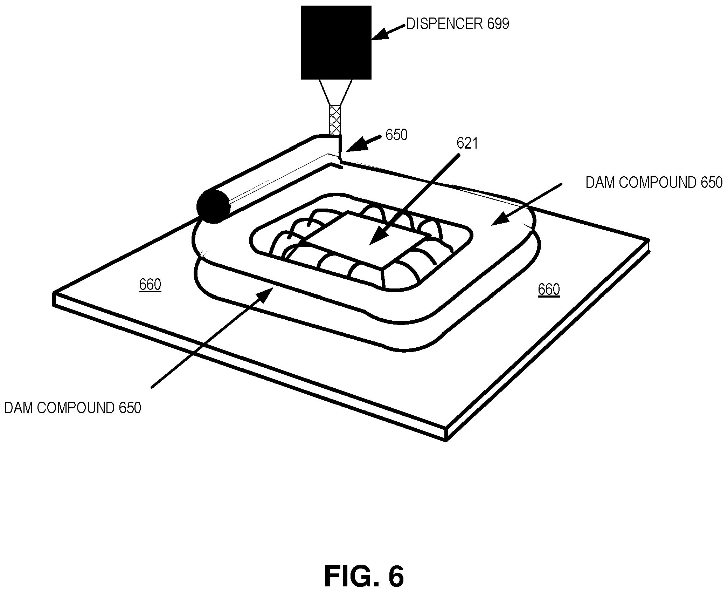

FIG. 6 illustrates an implementation where dam compound 650 is written directly to the bare image sensor to prepare the image sensor for active alignment with a lens assembly, in accordance with aspects of the disclosure. FIG. 6 shows an active region 621 of an image sensor package having wire bonds running to it. The image sensor package is electrically coupled to a circuit board 660. Dispenser 699 is moved while dam compound 650 is dispensed to form a platform of dam compound 650 for attaching a lens assembly to. For example, lens assemblies 330, 337, and/or 530 may be attached to the platform of dam compound.

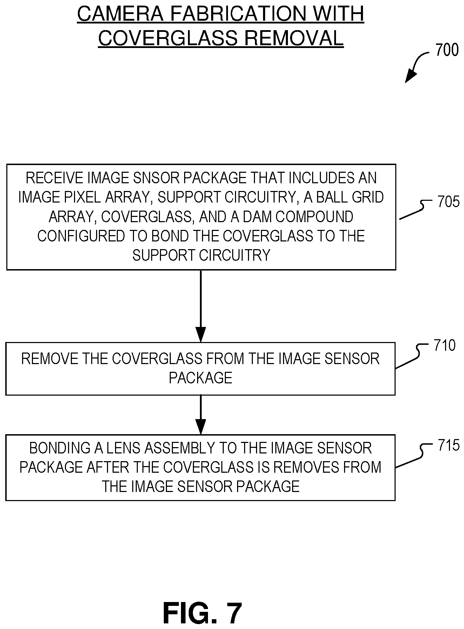

FIG. 7 illustrates a fabrication process 700 of a camera with coverglass removal, in accordance with aspects of the disclosure. The order in which some or all of the process blocks appear in process 700 should not be deemed limiting. Rather, one of ordinary skill in the art having the benefit of the present disclosure will understand that some of the process blocks may be executed in a variety of orders not illustrated, or even in parallel.

In process block 705, an image sensor package is received. The image sensor package includes: (1) an image pixel array; (2) support circuitry disposed around the image pixel array; (3) a ball grid array configured to electrically couple the support circuitry to a circuit board; (4) coverglass configured to protect the image pixel array and pass image light to the image pixel array; and (5) a dam compound configured to bond the coverglass to the support circuitry.

In process block 710, the coverglass is removed from the image sensor package. In process block 715, a lens assembly is bonded to the image sensor package after the coverglass has been removed from the image sensor package in process block 710.

In some implementations, process 700 further includes electrically coupling the ball grid array to the circuit board.

In some implementations of process 700, the dam compound is reused as a lens holder platform to bond the lens assembly to the support circuitry of the image sensor package.

In some implementations of process 700, the dam compound is reflowed to be reused as a lens holder platform to bond the lens assembly to the image sensor package.

In some implementations, the ball grid array of the image sensor package is configured to be the sole mechanical support of the lens assembly between the circuit board and lens assembly.

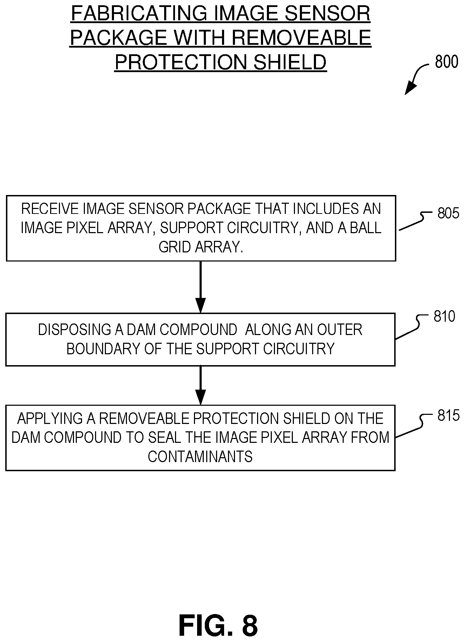

FIG. 8 illustrates a fabrication process 800 of a camera that includes a removeable protection shield, in accordance with aspects of the disclosure. The order in which some or all of the process blocks appear in process 800 should not be deemed limiting. Rather, one of ordinary skill in the art having the benefit of the present disclosure will understand that some of the process blocks may be executed in a variety of orders not illustrated, or even in parallel.

In process block 805, an image sensor package is received. The image sensor package includes: (1) an image pixel array; (2) support circuitry disposed around the image pixel array; and (3) a ball grid array configured to electrically couple the support circuitry to a circuit board.

In process block 810, a dam compound is disposed along an outer boundary of the support circuitry of the image sensor package.

In process block 815, a removeable protection shield is applied to the dam compound to seal the image pixel array from contaminants. The image sensor package with the removeable protection shield (e.g. tape or film) may be shipped to a module integrator and module integrator may remove the protection film before the image sensor package on a printed circuit board (either flex or rigid) is ready to accept the lens assembly to be bonded to the image sensor package.

Some implementations of process 800 further include: placing the image sensor package onto the circuit board by electrically coupling the ball grid array to the circuit board with a surface mount technology (SMT) machine; removing the removeable protection shield from the dam compound after the image sensor package has been placed onto the circuit board; and bonding the lens assembly to the dam compound. The bonding of the lens assembly to the image sensor package is performed subsequent to the removeable protection shield being removed.

In implementations of the disclosure, the lens structure of the lens assemblies may be square, circular, or irregular shapes based on the lens design. The z-direction (height) of the dam compound may vary to allow for the formation of additional glue surface area.

Embodiments of the invention may include or be implemented in conjunction with an artificial reality system. Artificial reality is a form of reality that has been adjusted in some manner before presentation to a user, which may include, e.g., a virtual reality (VR), an augmented reality (AR), a mixed reality (MR), a hybrid reality, or some combination and/or derivatives thereof. Artificial reality content may include completely generated content or generated content combined with captured (e.g., real-world) content. The artificial reality content may include video, audio, haptic feedback, or some combination thereof, and any of which may be presented in a single channel or in multiple channels (such as stereo video that produces a three-dimensional effect to the viewer). Additionally, in some embodiments, artificial reality may also be associated with applications, products, accessories, services, or some combination thereof, that are used to, e.g., create content in an artificial reality and/or are otherwise used in (e.g., perform activities in) an artificial reality. The artificial reality system that provides the artificial reality content may be implemented on various platforms, including a head-mounted display (HMD) connected to a host computer system, a standalone HMD, a mobile device or computing system, or any other hardware platform capable of providing artificial reality content to one or more viewers.

The term "processing logic" in this disclosure may include one or more processors, microprocessors, multi-core processors, Application-specific integrated circuits (ASIC), and/or Field Programmable Gate Arrays (FPGAs) to execute operations disclosed herein. In some embodiments, memories (not illustrated) are integrated into the processing logic to store instructions to execute operations and/or store data. Processing logic may also include analog or digital circuitry to perform the operations in accordance with embodiments of the disclosure.

A "memory" or "memories" described in this disclosure may include one or more volatile or non-volatile memory architectures. The "memory" or "memories" may be removable and non-removable media implemented in any method or technology for storage of information such as computer-readable instructions, data structures, program modules, or other data. Example memory technologies may include RAM, ROM, EEPROM, flash memory, CD-ROM, digital versatile disks (DVD), high-definition multimedia/data storage disks, or other optical storage, magnetic cassettes, magnetic tape, magnetic disk storage or other magnetic storage devices, or any other non-transmission medium that can be used to store information for access by a computing device.

Networks may include any network or network system such as, but not limited to, the following: a peer-to-peer network; a Local Area Network (LAN); a Wide Area Network (WAN); a public network, such as the Internet; a private network; a cellular network; a wireless network; a wired network; a wireless and wired combination network; and a satellite network.

Communication channels may include or be routed through one or more wired or wireless communication utilizing IEEE 802.11 protocols, short-range wireless protocols, SPI (Serial Peripheral Interface), I2C (Inter-Integrated Circuit), USB (Universal Serial Port), CAN (Controller Area Network), cellular data protocols (e.g. 3G, 4G, LTE, 5G), optical communication networks, Internet Service Providers (ISPs), a peer-to-peer network, a Local Area Network (LAN), a Wide Area Network (WAN), a public network (e.g. "the Internet"), a private network, a satellite network, or otherwise.

A computing device may include a desktop computer, a laptop computer, a tablet, a phablet, a smartphone, a feature phone, a server computer, or otherwise. A server computer may be located remotely in a data center or be stored locally.

The processes explained above are described in terms of computer software and hardware. The techniques described may constitute machine-executable instructions embodied within a tangible or non-transitory machine (e.g., computer) readable storage medium, that when executed by a machine will cause the machine to perform the operations described. Additionally, the processes may be embodied within hardware, such as an application specific integrated circuit ("ASIC") or otherwise.

A tangible non-transitory machine-readable storage medium includes any mechanism that provides (i.e., stores) information in a form accessible by a machine (e.g., a computer, network device, personal digital assistant, manufacturing tool, any device with a set of one or more processors, etc.). For example, a machine-readable storage medium includes recordable/non-recordable media (e.g., read only memory (ROM), random access memory (RAM), magnetic disk storage media, optical storage media, flash memory devices, etc.).

The above description of illustrated embodiments of the invention, including what is described in the Abstract, is not intended to be exhaustive or to limit the invention to the precise forms disclosed. While specific embodiments of, and examples for, the invention are described herein for illustrative purposes, various modifications are possible within the scope of the invention, as those skilled in the relevant art will recognize.

These modifications can be made to the invention in light of the above detailed description. The terms used in the following claims should not be construed to limit the invention to the specific embodiments disclosed in the specification. Rather, the scope of the invention is to be determined entirely by the following claims, which are to be construed in accordance with established doctrines of claim interpretation.

## Claims

1. A camera comprising:
an image sensor package including an image pixel array, support circuitry disposed around the image pixel array;
a lens assembly including a lens barrel disposed around lens elements configured to focus image light to the image pixel array; and
an adhesive adhering to the lens barrel to bond the lens barrel to the support circuitry in an inactive area of the image sensor package.

2. The camera of claim 1 further comprising:
a dam compound disposed between the adhesive and the inactive area of the image sensor package, wherein the dam compound was configured to adhere an image sensor coverglass to the image sensor package, and wherein the camera no longer includes the image sensor coverglass.

3. The camera of claim 2, wherein the dam compound includes glass fibers configured to bridge a coefficient of thermal expansion, CTE, between the image sensor package and the lens assembly.

4. The camera of any preceding claim, wherein the adhesive is added to bond the lens assembly directly to the image sensor package, and
optionally wherein:
the adhesive is disposed on substantially all of the inactive area of the image sensor package, or
the adhesive is disposed on an indented portion of the inactive area of the image sensor package, and wherein a width of the lens assembly is disposed inside the indented portion of the inactive area of the image sensor package.

5. The camera of any preceding claim, wherein a ball grid array of the image sensor package is configured to be the sole mechanical support of the lens assembly between a circuit board and the lens assembly.

6. The camera of any preceding claim, wherein the lens barrel is sized substantially similar to a length and width of the image sensor package.

7. The camera of any preceding claim, wherein the image sensor package has a length and a width, and wherein the lens barrel is sized no larger than 10% more than an area of the length multiplied by the width of the image sensor package.

8. The camera of any preceding claim, wherein the adhesive is configured to block ambient light from becoming incident on the image pixel array.

9. The camera of any preceding claim, wherein the lens assembly is not adhered to a molding configured to protect the image sensor package.

10. The camera of any preceding claim, wherein:
the image pixel array is an active region of the image sensor package and the support circuitry is an inactive area of the image sensor package, and/or
the image pixel array is a complementary metal-oxide semiconductor, CMOS, image pixel array.

11. A camera comprising:
an image sensor package including an image pixel array, support circuitry disposed around the image pixel array;
a lens assembly including a lens barrel disposed around lens elements configured to focus image light to the image pixel array;
a coverglass element configured to protect the image pixel array, wherein the coverglass element is disposed between the lens assembly and the image sensor package; and
an adhesive adhering the lens barrel to the coverglass element.

12. The camera of claim 11, wherein a ball grid array of the image sensor package is configured to be the sole mechanical support of the lens assembly between a circuit board and the lens assembly.

13. The camera of claim 11 or claim 12, wherein:
the lens barrel is sized substantially similar to a length and width of the image sensor package, and/or
wherein the image pixel array is a complementary metal-oxide semiconductor, CMOS, image pixel array.

14. A fabrication method comprising:
receiving an image sensor package, wherein the image sensor package includes:
an image pixel array;
support circuitry disposed around the image pixel array; and
a ball grid array configured to electrically couple the support circuitry to a circuit board;
disposing a dam compound along an outer boundary of the support circuitry of the image sensor package; and
applying a removeable protection shield on the dam compound to seal the image pixel array from contaminants.

15. The method of claim 14 further comprising:
placing the image sensor package onto the circuit board by electrically coupling the ball grid array to the circuit board with a surface mount technology, SMT, machine; and
removing the removeable protection shield from the dam compound after the image sensor package has been placed onto the circuit board; and
bonding a lens assembly to the dam compound subsequent to the removeable protection shield being removed, and
optionally wherein a lens barrel of the lens assembly is sized substantially similar to a length and width of the image sensor package.
